# EUROPÄISCHE PATENTSCHRIFT

(11) **EP 2 862 189 B1**
(45) Veröffentlichungstag und Bekanntmachung des Hinweises auf die Patenterteilung: **30.09.2015**
(21) Anmeldenummer: 13728114.3
(22) Anmeldetag: 04.06.2013
(51) Int. Cl.: H01H 1/021, H01H 1/20

(54) **SCHALTER**
SWITCH
COMMUTATEUR

(30) Priorität: 18.06.2012 DE 202012005934 U
(43) Veröffentlichungstag der Anmeldung: 22.04.2015
(73) Patentinhaber: Rosenberger Hochfrequenztechnik GmbH & Co. KG, 83413 Fridolfing (DE)
(72) Erfinder: MÜLLER, Thomas, 83471 Berchtesgarden (DE); ENTFSFELLNER, Christian, 83413 Fridolfing (DE)
(74) Vertreter: Zeitler Volpert Kandlbinder Patent- und Rechtsanwälte Partnerschaft mbB
(86) Internationale Anmeldenummer: PCT/EP2013/001635
(87) Internationale Veröffentlichungsnummer: WO 2013/189570

(56) Entgegenhaltungen:
- EP-A1- 1 675 148
- US-A1- 2002 140 533
- US-A1- 2004 005 871
- US-A1- 2004 160 726

## Beschreibung

Die Erfindung betrifft einen Schalter zum bedarfsweisen elektrischen Verbinden von mindestens zwei Leitungen und insbesondere einen Schalter, mit dem mindestens zwei, mit den Leitungen verbundene elektronische Bauteile temporär miteinander zur Übertragung von Hochfrequenzsignalen verbunden werden.

Bei einem der elektronischen Bauteile kann es sich insbesondere um ein Intermodulationsmessgerät handeln, mit dem eine Intermodulation der von dem anderen elektronischen Bauteil erzeugten Hochfrequenzsignale getestet werden sollen. Es ist ersichtlich, dass dazu erforderlich ist, dass der Schalter selbst möglich keine Intermodulation der Hochfrequenzsignale bewirkt, um das Messergebnis nicht zu verfälschen.

Ein Schalter gemäß dem Oberbegriff des Anspruchs 1 ist aus US 2004/005871 A1 bekannt.

Ausgehend von diesem Stand der Technik lag der Erfindung die Aufgabe zugrunde, einen insbesondere hinsichtlich seines Intermodulationsverhaltens verbesserten Schalter anzugeben.

Diese Aufgabe wird durch einen Schalter gemäß dem unabhängigen Anspruch 1 gelöst. Vorteilhafte Ausgestaltungen des erfindungsgemäßen Schalters sind Gegenstand der abhängigen Ansprüche und ergeben sich aus der nachfolgenden Beschreibung der Erfindung. Eine Schaltereinheit mit mindestens zwei erfindungsgemäßen Schaltern ist zudem Gegenstand des nebengeordneten Anspruchs 8.

Ein gattungsgemäßer Schalter zum bedarfsweisen elektrischen Verbindungen von mindestens zwei Leitungen, der ein Gehäuse mit mindestens zwei Anschlüssen zur Anbindung der Leitungen, einen ersten, mit einem ersten der Anschlüsse verbundenen Leiter, einem zweiten, mit einem zweiten der Anschlüsse verbundenen Leiter sowie (mindestens) einen Verbindungsleiter aufweist, der mittels einer Betätigungseinrichtung bedarfsweise in Kontakt mit den beiden Leitern bringbar ist, ist erfindungsgemäß dadurch gekennzeichnet, dass im geschlossenen Zustand des Schalters zumindest einer, vorzugsweise alle der Leiter mit dem Verbindungsleiter indirekt über ein Dielektrikum kontaktiert ist/sind.

Durch die dielektrische Trennung der insbesondere für die Übertragung von Hochfrequenzsignalen vorgesehenen Leiter kann deren Übertragung mit einer nur geringen Intermodulation, ggf. sogar weitgehend intermodulationsfrei erfolgen.

Bei dem Dielektrikum handelt es sich vorzugsweise um eine Schicht, die auf zumindest einer, vorzugsweise beiden Kontaktflächen der entsprechenden Kontaktflächenpaarung (Leiter und Verbindungsleiter) vorgesehen ist.

Vorzugsweise weist die Schicht eine Dicke von ≤ 0,1 mm.

Weiterhin bevorzugt kann vorgesehen sein, dass das Dielektrikum auf einem Polyimid, Teflon oder Kapton basiert und insbesondere in Form einer Polyimid-Folie ausgebildet ist.

In einer weiterhin bevorzugten Ausführungsform des erfindungsgemäßen Schalters kann vorgesehen sein, dass Kontaktflächen der zwei Leiter und des Verbindungsleiters schräg bezüglich der Längsachsen des dazugehörigen Leiters oder Verbindungsleiters ausgebildet sind. Dadurch können die Kontaktflächen relativ groß im Vergleich zu der Querschnittsfläche des Leiters oder Verbindungsleiters ausgebildet werden, wodurch insbesondere eine relativ geringe Durchgangsdämpfung für über die Leiter bzw. Verbindungsleiter geführte Hochfrequenzsignale erreicht werden kann.

Dabei ist besonders bevorzugt vorgesehen, dass sowohl die Kontaktflächen der beiden Leiter als auch die Kontaktflächen des Verbindungsleiters jeweils gegenläufig schräg ausgebildet sind. Dadurch kann von den beiden Leitern eine sich verjüngende Aufnahme ausgebildet werden, in der der sich entsprechend verjüngende Verbindungsleiter formschlüssig aufgenommen werden kann. Die Aufnahme bildet dadurch für den mittels der Betätigungseinrichtung betätigten Verbindungsleiter einen Anschlag (Endlage einer Betätigungsbewegung) aus.

Eine weiterhin bevorzugte Ausführungsform des erfindungsgemäßen Schalters sieht vor, den Verbindungsleiter mittels der Betätigungseinrichtung rein translatorisch bewegbar auszugestalten, wodurch eine konstruktiv einfache und robuste Ausgestaltung des erfindungsgemäßen Schalters realisiert werden kann.

Weiterhin bevorzugt ist vorgesehen, dass der Schalter geöffnet ist, sofern die Betätigungseinrichtung nicht betätigt ist. Dies kann vorzugsweise dadurch erreicht werden, dass der Verbindungsleiter mittels eines Federelements in seine geöffnete Stellung beaufschlagt ist.

In einer besonders bevorzugten Ausführungsform des erfindungsgemäßen Schalters kann vorgesehen sein, dass mindestens zwei erfindungsgemäße Schalter in einer Schaltereinheit kombinieren sind, wobei dieser in dem Gehäuse drei Anschlüsse und drei damit verbundene Leiter sowie zwei Verbindungsleiter umfasst. Demnach wird einer der Leiter von beiden Verbindungsleitern kontaktiert. Eine solche Schaltereinheit eignet sich insbesondere zur Durchführung von zwei verschiedenen Tests an einem einzelnen elektronischen Bauteil, wobei das zu testende elektronische Bauteil an denjenigen Anschluss angeschlossen ist, dessen Leiter mit beiden Verbindungsleitern bedarfsweise kontaktiert werden kann.

Die Erfindung wird nachfolgend anhand eines in der Zeichnung dargestellten Ausführungsbeispiels näher erläutert. In der Zeichnung zeigt:

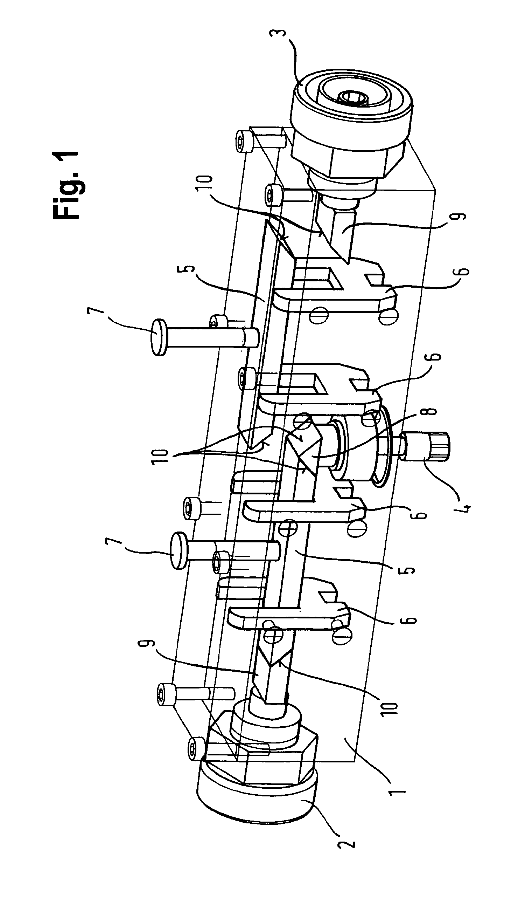

- Fig. 1:: eine erfindungsgemäße Schaltereinheit in einer isometrischen Ansicht.

Die in der Fig. 1 dargestellte Schaltereinheit umfasst zwei erfindungsgemäße Schalter, die in einem gemeinsamen Gehäuse 1 integriert sind. Hierzu weist das Gehäuse 1 insgesamt drei Anschlüsse 2, 3, 4 auf, von denen ein erster (2) und ein zweiter (3) jeweils auf einer der beiden Stirnseiten und ein dritter (4) an einer der Längsseiten des Gehäuses 1 angeordnet ist. Der dritte, an der Längsseite angeordnete Anschluss 4 dient der Anbindung einer Leitung, die mit einem zum testenden elektronischen Bauteil verbunden ist. An den beiden an den Stirnseiten angeordneten Anschlüssen 2, 3 können zwei Messgeräte angeschlossen werden, bei denen es sich beispielsweise um ein Netzanalysegerät sowie um ein Intermodulationsmessgerät handeln kann.

Zur Durchführung von Messungen können die beiden Messgeräte mittels der Schaltereinheit bedarfsweise mit dem zu testenden elektronischen Bauteil verbunden werden. Dies erfolgt mittels zwei in die Schaltereinheit integrierten erfindungsgemäßen Schaltern, über die im geschlossenen Zustand dann von dem zu testenden elektronischen Bauteil erzeugte Hochfrequenzsignale geleitet werden.

Jeder dieser Schalter umfasst einen Verbindungsleiter 5, der als starres Leiterelement mit einem rechteckigen Querschnitt ausgebildet ist. Die Verbindungsleiter 5 sind jeweils in zwei Führungen 6 translatorisch verschiebbar gelagert, wobei eine Bewegung der Verbindungsleiter 5 durch die Betätigung einer Betätigungseinrichtung in Form einer Betätigungstaste 7 vorgenommen werden kann. Durch das Ausüben einer Druckkraft auf die Betätigungstaste 7 eines der Verbindungsleiter 5 wird dieser gegen die Kraft eines (nicht dargestellten) Federelements in den zwei dazugehörigen Führungen 6 verschoben, bis der Verbindungsleiter 5 in Kontakt mit zwei Leitern 8, 9 gerät, von denen ein erster (8) (elektrisch leitend) mit demjenigen Anschluss 4, der an der Seitenfläche des Gehäuses 1 angeordnet ist, und der zweite (9) mit dem, zu dem jeweiligen Schalter zugehörigen, in der Stirnseite angeordneten Anschluss 2, 3 verbunden ist. Auch die Leiter 8, 9 sind (zumindest abschnittsweise) als starre Leiterelemente mit einem rechteckigen Querschnitt ausgebildet.

Der Kontakt zwischen den (aus elektrisch leitfähigem Material ausgebildeten) Verbindungsleitern 5 und dem (aus elektrisch leitfähigem Material ausgebildeten) Leitern 8, 9 ist nicht direkt, sondern erfindungsgemäß erfolgt indirekt über Dielektrika, die auf jeder der Kontaktflächen 10 der Leiter 8, 9 und der Verbindungsleiter 5 in Form von PolyimidFolien ausgebildet sind. Durch den indirekten Kontakt der Leiter 8, 9 mit den Verbindungsleitern 5 erfolgt die Übertragung der Hochfrequenzsignale funktional über zwei Kondensatoren und im Ergebnis weitgehend intermodulationsfrei.

Um die Eignung der erfindungsgemäßen Schaltereinheit zur Übertragung von Hochfrequenzsignalen weiter zu verbessern, ist vorgesehen, alle zur Übertragung von Hochfrequenzsignalen vorgesehenen Bauteile, d.h. insbesondere die drei Anschlüsse 2, 3, 4, die drei Leiter 8, 9 sowie die beiden Verbindungsleiter 5 mit einer Impedanz von jeweils 50 Ω auszubilden. Dies erfolgt über eine entsprechende Auswahl des jeweiligen Werkstoffs in Kombination mit der dazugehörigen Geometrie, insbesondere Querschnittsgeometrie des jeweiligen Bauteils.

Weiterhin sind die Kontaktflächen 10 der Leiter 8, 9 bzw. der Verbindungsleiter 5, die im geschlossenen Zustand der Schalter kontaktieren, schräg bezüglich der Längsachsen der dazugehörigen Bauteile ausgebildet. Dadurch kann erreicht werden, dass die Kontaktflächen 10 verglichen mit der Querschnittsfläche des dazugehörigen Bauteils relativ groß sind, wodurch eine relativ geringe Durchgangsdämpfung erreicht werden kann.

## Patentansprüche

1. Schalter zur bedarfsweisen elektrischen Verbindung von mindestens zwei Leitungen, mit einem Gehäuse (1) mit mindestens zwei Anschlüssen (2, 3, 4) zur Anbindung der Leitungen, mit einem ersten, mit einem ersten Anschluss (4) verbundenen Leiter (8) und einem zweiten, mit einem zweiten Anschluss (2, 3) verbundenen Leiter (9) sowie mit einem Verbindungsleiter (5), der zum Schließen des Schalters mittels einer Betätigungseinrichtung in Kontakt mit den beiden Leitern (8, 9) bringbar ist, wobei zumindest einer der Leiter (8, 9) und der Verbindungsleiter (5) im geschlossenen Zustand des Schalters indirekt über ein Dielektrikum kontaktiert sind, **dadurch gekennzeichnet, dass** der Verbindungsleiter (5) mittels der Betätigungseinrichtung translatorisch bewegbar ist.

2. Schalter gemäß Anspruch 1, **dadurch gekennzeichnet, dass** das Dielektrikum eine Schicht mit einer Dicke von ≤ 0,1 mm ist.

3. Schalter gemäß Anspruch 1 oder 2, **dadurch gekennzeichnet, dass** das Dielektrikum auf einem Polyimid, Teflon oder Kapton basiert.

4. Schalter gemäß einem der vorhergehenden Ansprüche, **dadurch gekennzeichnet, dass** Kontaktflächen (10) der zwei Leiter (8, 9) und des Verbindungsleiters (5) schräg bezüglich der Längsachsen des dazugehörigen Leiters (8, 9) oder Verbindungsleiters (5) ausgebildet sind.

5. Schalter gemäß Anspruch 4, **dadurch gekennzeichnet, dass** sowohl die Kontaktflächen (10) der Leiter (8, 9) als auch die Kontaktflächen (10) des Verbindungsleiters (5) gegenläufig schräg ausgebildet sind.

6. Schalter gemäß einem der vorhergehenden Ansprüche, **dadurch gekennzeichnet, dass** der Verbindungsleiter (5) mittels eines Federelements in seine geöffnete Stellung beaufschlagt ist

7. Schalter gemäß einem der vorhergehenden Ansprüche, **dadurch gekennzeichnet, dass** die Anschlüsse (2, 3, 4), die Leiter (8, 9) und der Verbindungsleiter (5) eine Impedanz von 50 Ω aufweisen.

8. Schaltereinheit mit zwei Schaltern gemäß einem der vorhergehenden Ansprüche, wobei drei Anschlüsse (2, 3, 4) und drei damit verbundene Leiter (8, 9) sowie zwei Verbindungsleiter (5) vorhanden sind.

## Claims

1. Switch for electrically connecting at least two lines as and when required, having a housing (1) having at least two terminals (2, 3, 4) for the lines to be connected to, having a first conductor (8) connected to a first terminal (4), and a second conductor (9) connected to a second terminal (2, 3) and having a connecting conductor (5) which can be brought into contact with the two conductors (8, 9) by means of an actuating device in order to close the switch, at least one of the conductors (8, 9) and the connecting conductor (5) being in contact indirectly via a dielectric when the switch is in the closed state, **characterised in that** the connecting conductor (5) is movable in translation by means of the actuating device.

2. Switch according to claim 1, **characterised in that** the dielectric is a layer of a thickness of ≤ 0.1 mm.

3. Switch according to claim 1 or 2, **characterised in that** the dielectric is based on a polyimide, Teflon or Kapton.

4. Switch according to one of the preceding claims, **characterised in that** contact-making surfaces (10) of the two conductors (8, 9) and the connecting conductor (5) are of an oblique form relative to the longitudinal axes of the associated conductor (8, 9) or connecting conductor (5).

5. Switch according to claim 4, **characterised in that** both the contact-making surfaces (10) of the conductors (8, 9) and the contact-making surfaces (10) of the connecting conductor (5) are of an oblique form in opposite directions.

6. Switch according to one of the preceding claims, **characterised in that** the connecting conductor (5) is loaded into its open position by means of a resilient member.

7. Switch according to one of the preceding claims, **characterised in that** the terminals (2, 3, 4), the conductors (8, 9) and the connecting conductor (5) have an impedance of 50Ω.

8. Switch unit having two switches according to one of the preceding claims, there being three terminals (2, 3, 4) and three conductors (8, 9) connected thereto plus two connecting conductors (5).

## Revendications

1. Commutateur pour la liaison électrique d'au moins deux lignes selon les besoins, comprenant un boîtier (1) avec au moins deux bornes (2, 3, 4) pour la connexion des lignes, comprenant un premier conducteur (8) connecté à une première borne (4) et un second conducteur (9) connecté à une seconde borne (2, 3), et comprenant un conducteur de liaison (5) qui, afin de fermer le commutateur au moyen d'un dispositif d'actionnement, est susceptible d'être amené en contact avec les deux conducteurs (8, 9), dans lequel l'un au moins des conducteurs (8, 9) et le conducteur de liaison (5) sont mis en contact indirectement via un diélectrique dans la situation fermée du commutateur,
**caractérisé en ce que** le conducteur de liaison (5) est déplaçable en translation au moyen du dispositif d'actionnement.

2. Commutateur selon la revendication 1, **caractérisé en ce que** le diélectrique est une couche avec une épaisseur ≤ 0,1 mm.

3. Commutateur selon la revendication 1 ou 2, **caractérisé en ce que** le diélectrique est à base de polyimide, de Téflon ou de Kapton.

4. Commutateur selon l'une des revendications précédentes, **caractérisé en ce que** les surfaces de contact (10) des deux conducteurs (8, 9) et du conducteur de liaison (5) sont réalisées en oblique par rapport aux axes longitudinaux du conducteur associé (8, 9) ou du conducteur de liaison (5).

5. Commutateur selon la revendication 4, **caractérisé en ce que** les surfaces de contact (10) des conducteurs (8, 9) tout comme les surfaces de contact (10) du conducteur de liaison (5) sont réalisées en oblique en sens opposés.

6. Commutateur selon l'une des revendications précédentes, **caractérisé en ce que** le conducteur de liaison (5) est sollicité vers sa position ouverte au moyen d'un élément à ressort.

7. Commutateur selon l'une des revendications précédentes, **caractérisé en ce que** les bornes (2, 3, 4), les conducteurs (8, 9) et le conducteur de liaison (5) ont une impédance de 50 ohms.

8. Unité à commutateur comprenant de commutateur selon l'une des revendications précédentes, dans laquelle il est prévu trois bornes (2, 3, 4) et trois conducteurs (8, 9) reliés à celles-ci, ainsi que deux conducteurs de liaison (5).
